# EUROPÄISCHE PATENTSCHRIFT

(11) **EP 1 405 334 B1**
(45) Veröffentlichungstag und Bekanntmachung des Hinweises auf die Patenterteilung: **27.11.2013**
(21) Anmeldenummer: 02745028.7
(22) Anmeldetag: 09.07.2002
(51) Int. Cl.: H01L 21/00

(54) **VORRICHTUNG UND VERFAHREN ZUM HARMONISIERTEN POSITIONIEREN VON WAFERSCHEIBEN**
DEVICE AND METHOD FOR HARMONISED POSITIONING OF WAFER DISKS
DISPOSITIF ET PRODEDE DE POSITIONNEMENT HARMONISE DE TRANCHES DE SILICIUM

(30) Priorität: 12.07.2001 CH 128301
(43) Veröffentlichungstag der Anmeldung: 07.04.2004
(73) Patentinhaber: Brooks-PRI Automation (Switzerland) GmbH, 8274 Tägerwilen (CH)
(72) Erfinder: BLATTNER, Jakob, CH-8272 Ermatingen (CH)
(74) Vertreter: Klein, Friedrich
(86) Internationale Anmeldenummer: PCT/CH2002/000375
(87) Internationale Veröffentlichungsnummer: WO 2003/009340

(56) Entgegenhaltungen:
- EP-A- 0 376 160
- US-A- 5 533 243
- US-A- 5 970 818
- US-A- 6 052 913

## Beschreibung

Die vorliegende Erfindung betrifft eine Vorrichtung zum harmonisierten Positionieren einer Vielzahl von Waferscheiben sowie ein Verfahren dazu. Speziell betrifft die Erfindung eine Vorrichtung, mit der eine Vielzahl von senkrecht gelagerten, in etwa kreisförmigen Waferscheiben bezüglich einer im Außenumfang ausgebildeten Kerbe harmonisiert ausgerichtet werden.

Die in den Herstellungsprozess eingebrachten Waferscheiben sind - in einem bestimmten Stadium ihrer Bearbeitung - als in etwa kreisförmige Scheiben geschnitten. Aus unterschiedlichen Gründen - zu denen einerseits die kristalline Ausrichtung in der Scheibenebene und andererseits die Anbringung von aufgebrachten Kennzeichnungen z.B. im äußeren Bereich der Waferscheiben gehören - ist es notwendig, eine Charge Waferscheiben bezüglich ihrer azimutalen Ausrichtung harmonisiert zu positionieren. Dies wird durchgeführt, wenn die Waferscheiben nebeneinander stehend auf einer Vorrichtung angeordnet sind. Aus der US-A-6 052 913 ist zwar auch eine Anordnung und ein Verfahren bekannt, bei der die Waferscheiben übereinander liegend - z.B. in der Reaktionskammer - azimutal positioniert werden, jedoch hat dies wesentliche Nachteile, die einerseits darin liegen, dass bei einer stehenden Anordnung kleinste Partikel in der durchströmenden Luft oder Gas sich nicht auf den Waferscheiben absetzen und anderseits eine azimutale Positionierung bei einer senkrechten Lagerung der Waferscheiben bezüglich der zuvor und danach durchzuführenden Verarbeitungsprozesse zu bevorzugen ist.

Zur harmonisierten Positionierung sind die Waferscheiben mit einer Kerbe (Notch) im Außenumfang versehen. Diese kann entweder als in etwa dreieckiger oder als kreissegmentförmiger Einschnitt vorliegen.

Aus der US-A-5 533 243 ist eine Vorrichtung und ein dazugehöriges Verfahren bekannt, bei der senkrecht angeordnete Waferscheiben gelagert sind auf einer Antriebsrolle und einer weiteren Rolle, auf der eine Vielzahl von frei laufenden Rädchen aufgezogen sind. Die azimutale Harmonisierung der einzelnen Kerben wird entsprechend dem Vorschlag der US-A-5 533 243 so vorgenommen, dass die kreis-segmentförmigen Kerben die Bewegung der Waferscheiben durch die Antriebsrolle verhindern, wenn die Kerben bei der Antriebsrolle angelangt sind. Danach werden die Waferscheiben gemeinsam mit einer weiteren angetriebenen Rolle (Kerbenbewegungsrolle) in eine gewünschte Position gedreht. Dieses Verfahren ist aber mit zahlreichen Nachteilen behaftet. Einerseits sind für die Vorrichtung Waferscheiben mit kreissegmentförmigen Einschnitten notwendig, was in der Praxis nicht immer zutrifft. Andererseits ist das Verfahren aber auch durch die Vielzahl von angetriebenen Rollen und die Änderung der Höhenposition der Waferscheiben während der verschiedenen Phasen der Ausrichtung störanfällig und den Waferscheiben wegen der Partikelgenerierung der Rollenantriebe nicht zuträglich.

Aus der US-A-5 662 452 ist eine Vorrichtung bekannt, in der eine Ausrichtungsstange von einer Antriebsrolle gedreht wird und dabei die stehend gelagerten Waferscheiben solange dreht, bis die ebenfalls kreissegmentförmigen Kerben in die - kleiner als diese bemessene - Ausrichtungsstange einrasten und damit keine weitere Drehung möglich ist. Auch diese Vorrichtung ist mit technischen Nachteilen behaftet, denn einerseits sind wiederum nur Waferscheiben mit kreissegmentförmigen Kerben positionierbar und andererseits ist die Vorrichtung so ausgebildet, dass die Ausrichtungsstangen in den Kerben weiter drehen und eine - Abrieb erzeugende - Reibung erzeugen, bis der Vorgang beendet ist und alle Waferscheiben ausgerichtet sind. Weiterhin ist hier ebenfalls der Nachteil gegeben, dass während des Ausrichtvorganges die Waferscheiben durch das Einrasten ihre Höhe verändern. Weiterhin wesentlich ist der Nachteil, dass für die Sicherheit des Einrastens eine langsame Phase vorgesehen werden muss, die es zu vermeiden gilt.

Ein den beiden vorgenannten Verfahren ähnliches Verfahren ist aus der US-A-5 853 284 bekannt, bei der die Kraftübertragung beim Einrasten der angetriebenen Rolle in die - notwendigerweise kreissegmentförmigen Kerben - durch eine leichte Höhenveränderung dadurch gestoppt wird, indem die Kraftübertragung auf die Rolle als Rutschkupplung ausgebildet ist. Dies führt neben den oben genannten Nachteilen einer Höhenveränderung - ebenfalls zu einem Abrieb, der - erfindungsgemäß - vermieden werden soll.

Aus der US-A-5 970 818 ist eine Vorrichtung bekannt, die grundsätzlich schon Waferscheiben mit dreieckigen Kerben zu positionieren vermag, aber ohne die Nachteile des vorgenannten Standes der Technik zu überwinden. Es wird nämlich ebenfalls von einem Absenken der Waferscheiben Gebrauch gemacht, wobei dann die Waferscheiben so tief fallen, dass eine eigens dafür eingerichtete Bremseinrichtung eine weitere Drehung der Waferscheiben verhindert, allerdings wiederum unter Inkaufnahme eines Rutschens der Antriebsrolle auf der Waferscheibe.

Aus der vorgenannten US-A-5 533 243 ist schon bekannt, die Position der Kerben mit einem optischen Sensor zu überprüfen, dort allerdings nur zum Feststellen, dass sich die Kerben aller Waferscheiben in gleicher Position befinden, nämlich in einer Reihe liegen, durch die der optische Strahl hindurchgelangen kann - oder eben nicht.

Es ist also die Aufgabe der vorliegenden Erfindung, eine Vorrichtung zur Ausrichtung von senkrecht stehenden Waferscheiben zu entwickeln und ein Verfahren vorzuschlagen, bei denen die vorstehend beschriebenen Nachteile der Vorrichtungen und Verfahren gemäß dem Stand der Technik vermieden werden, insbesondere die Höhenposition der Waferscheiben während des Ausrichtens nicht verändert wird, ein Abrieb an den Waferscheiben oder in ihrer Nähe vermieden wird und auch Waferscheiben mit unterschiedlich gestalteten Kerben ausgerichtet werden können. Weiterhin soll die Vorrichtung einfach sein und keine überflüssigen und störenden Bremsen aufweisen, die die Waferscheiben beschädigen können oder deren Abrieb sich auf den Waferscheiben niederzuschlagen vermag. Des weiteren ist es die Aufgabe der Erfindung, die langsame Phase beim Einrasten zu vermeiden und damit einen schnelleren Vorgang zu ermöglichen.

Die Erfindung löst die Aufgabe durch eine Vorrichtung nach Anspruch 1. Dabei haben die Maßnahmen der Erfindung zunächst einmal zur Folge, dass beim Drehen der Waferscheiben zum Zwecke des Ausrichtens kein durch eine Rutschkupplung oder eine Bremswirkung an den Waferscheiben erzeugter Abrieb auftritt, der sich auf den Waferscheiben niederschlagen könnte. Weiterhin haben die Maßnahmen der Erfindung zur Folge, dass die Waferscheiben während des Ausrichtvorganges alle die gleiche Höhenlage einnehmen, die sich nicht verändert. Das aus dem Stand der Technik beschriebene mechanische Einrasten kann also vollständig vermieden werden. Eine bestimmte Form der Positionierungskerben ist nicht notwendig, ebenso ist deren Größe nicht vorgeschrieben.

Besonders vorteilhaft ist ein Verfahren nach Anspruch 9, bei dem eine Schnellausrichtung der Waferscheiben in einer ersten Drehrichtung und eine Feinausrichtung in der entgegengesetzten Drehrichtung vorgenommen wird, da dann keine Abstimmung der - ersten, höheren - Drehgeschwindigkeit und der Genauigkeit der Detektierung der Kerben notwendig ist, sondern diese auf die Feinabstimmung verlagert werden kann.

Weitere vorteilhafte Einzelheiten der Erfindung sind in den abhängigen Ansprüchen dargelegt.

Die vorgenannten sowie die beanspruchten und in den nachfolgenden Ausführungsbeispielen beschriebenen, erfindungsgemäß zu verwendenden Elemente unterliegen in ihrer Größe, Formgestaltung, Materialverwendung und technischen Konzeption keinen besonderen Ausnahmebedingungen, so dass die in dem jeweiligen Anwendungsgebiet bekannten Auswahlkriterien uneingeschränkt Anwendung finden können.

Weiterhin ist die Vorrichtung nicht auf die Positionierung von Waferscheiben beschränkt. Sowohl die Vorrichtung als auch das Verfahren lassen sich für andere Scheiben, wie z.B. CDs etc. verwenden.

Weitere Einzelheiten, Merkmale und Vorteile des Gegenstandes der Erfindung ergeben sich aus der nachfolgenden Beschreibung der dazugehörigen Zeichnungen, in denen - beispielhaft - eine Vorrichtung und ein dazugehöriger Verfahrensablauf zur vorliegenden Erfindung erläutert wird.

In den Zeichnungen zeigen:
Fig. 1 eine Seitenansicht der Vorrichtung zur Positionierung von Waferscheiben gemäß einem ersten Ausführungsbeispiel der vorliegenden Erfindung;

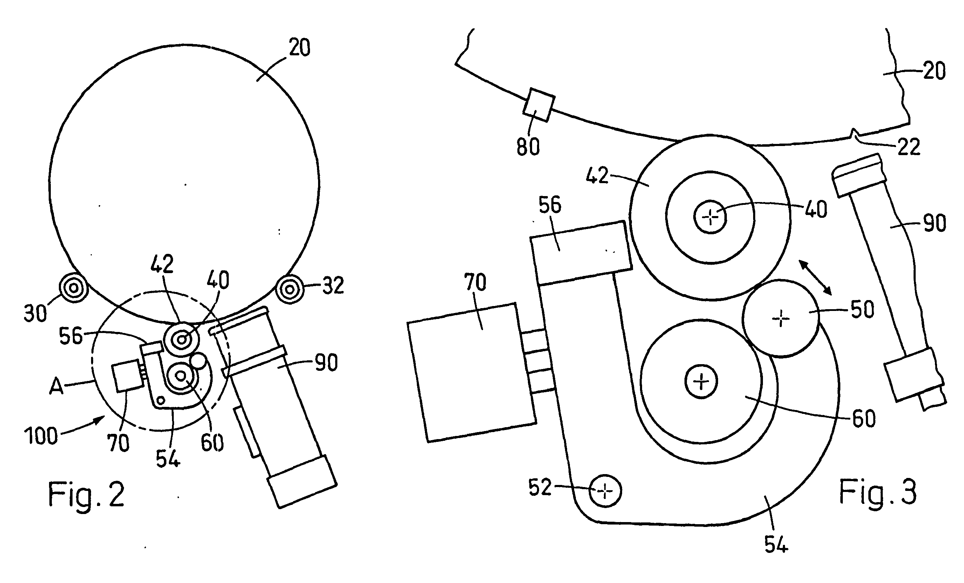

Fig. 2 eine schematische Darstellung der Vorrichtung nach Figur 1;
Fig. 3 eine Detailzeichnung des Ausschnittes A aus Figur 2;

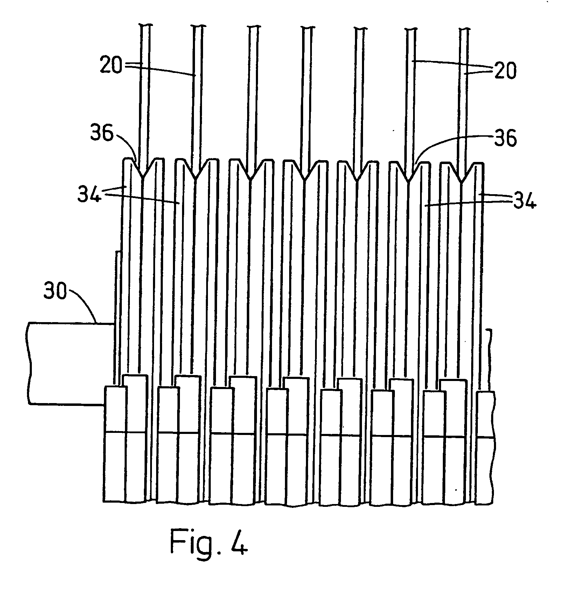

Fig. 4 eine Detailzeichnung der Antriebsrollen und der Führungsrollen des ersten Ausführungsbeispiels;

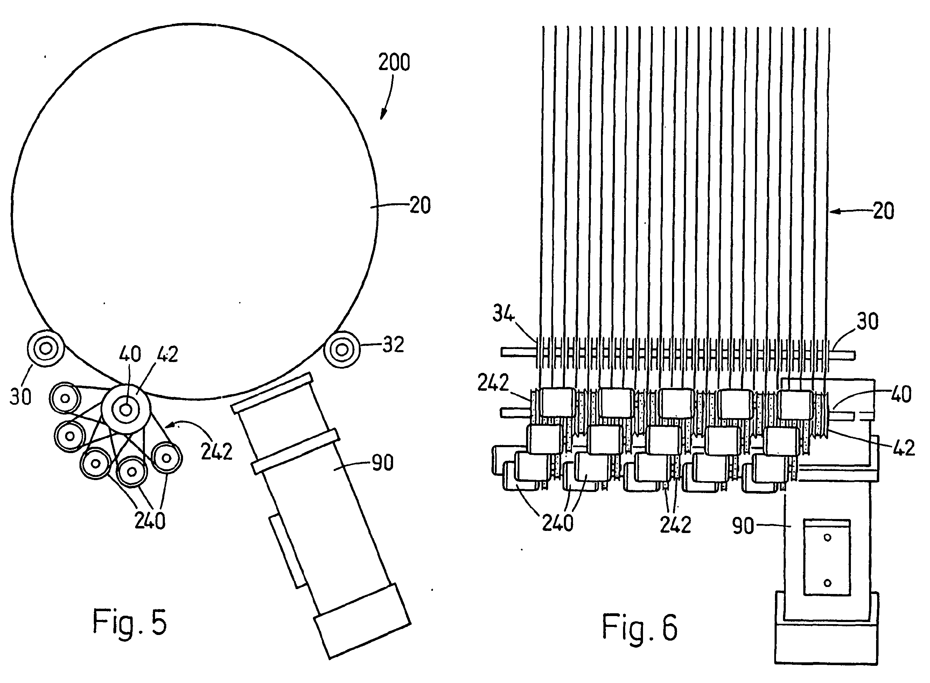

Fig. 5 eine Seitenansicht der Vorrichtung zur Positionierung von Waferscheiben gemäß einem zweiten Ausführungsbeispiel der vorliegenden Erfindung; und
Fig. 6 eine Ansicht von vorne auf die Vorrichtung nach Figur 5.

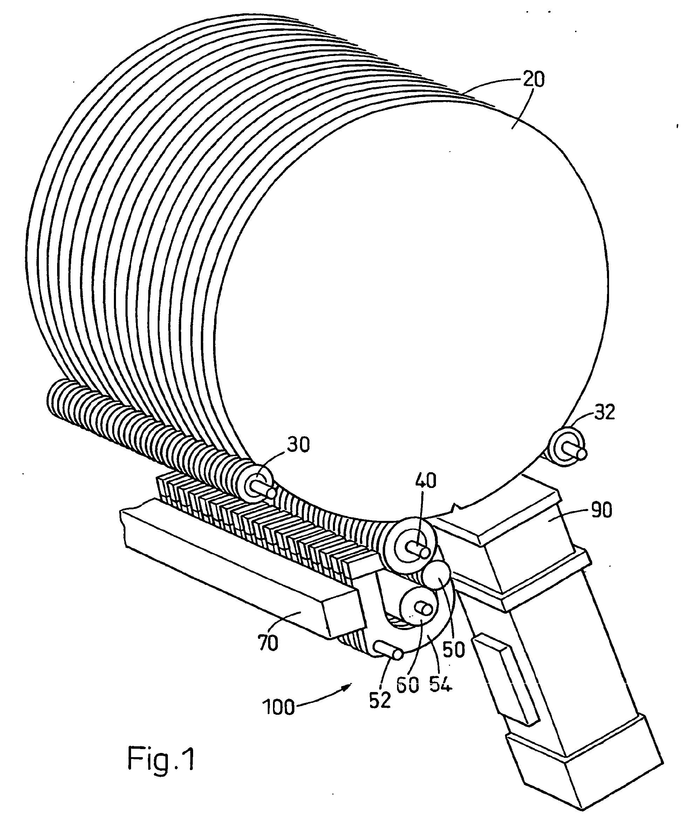

In einer in Figur 1 als Ganzes mit 100 bezeichneten Vorrichtung zur Positionierung von Waferscheiben stehen die Waferscheiben 20 so auf den Führungsrollen 34 einer ersten und einer zweiten Lagerungsrolle 30 und 32, dass sie durch V-Kerben 36 in den Führungsrollen 34 senkrecht gehalten werden. Die Führungsrollen sind einzeln gelagert, so dass eine Bewegung einer Waferscheibe keine Bewegung einer anderen Waferscheibe veranlasst.

Die Waferscheiben werden im ersten Ausführungsbeispiel durch die auf einer feststehenden, also nicht umlaufenden Achse 40 aufgezogenen, einzeln gelagerten Antriebsrollenelemente 42, jeweils mit einer V-Kerbe, angetrieben. Die Antriebsrollenelemente 42 werden im ersten Ausführungsbeispiel dadurch selektiv angetrieben, dass die Drehbewegung einer zweiten Antriebsrolle 60, die mit einem Elektromotor angetrieben wird, mit Hilfe einer Übertragungsrolle 50 auf das Antriebsrollenelement 42 übertragen wird. Es ist für jedes Antriebsrollenelement 42 eine Übertragungsrolle 50 vorgesehen, von denen eine die selektive Kopplung bewirkt. Jede Übertragungsrolle 50 kann zwei Zustände einnehmen, nämlich einerseits den gekoppelten Zustand, in dem sie mit dem ihr zugeordneten Antriebsrollenelement 42 und der zweiten Antriebsrolle 60 in Verbindung steht und einem ungekoppelten Zustand, in dem sie mit zumindest einem der vorgenannten Elemente - das ihr zugeordnete Antriebsrollenelement 42 und die zweiten Antriebsrolle 60 - gelöst ist. Im Ausführungsbeispiel stehen die Übertragungsrollen 50 im ungekoppelten Zustand mit keinem der genannten Elemente in Verbindung.

Die Kopplung bzw. Entkopplung wird im vorliegenden Ausführungsbeispiel mit Hebeln 54 bewirkt, die um einen Drehpunkt 52 geschwenkt werden und an deren einem Ende die Übertragungsrollen 50 angebracht sind. Am anderen Ende der Hebel 54 sind Bremselemente 56 angebracht, die im ungekoppelten Zustand der jeweiligen Übertragungsrollen 50 das jeweilige Antriebsrollenelement 42 bremsen. Das Schwenken der Hebel 54 in den gekoppelten Zustand bzw. in den ungekoppelten Zustand wird durch Aktorelemente 70 bewirkt, die so angeordnet sind, dass sich jeder Hebel einzeln in den gekoppelten bzw. in den ungekoppelten Zustand bewegen lässt. In einer Ausführung dieses Ausführungsbeispiels werden die Aktorelemente 70 pneumatisch bewegt und durch eine Steuerungseinrichtung angesteuert. In einer alternativen Ausführung werden die Aktorelemente 70 magnetisch bewegt. Für die Aktorelemente 70 können aber alle anderen Ausführungen vorgesehen werden, mit denen die vorgesehene Aktion ausgelöst werden kann.

Für jede Waferscheibe ist in diesem Ausführungsbeispiel eine Sensoreinheit 80 vorgesehen, die ein Signal auslöst, sobald an einer bestimmten azimutalen Position die Ausrichtungskerbe 22 der Waferscheibe erkannt wird. Es kommen dabei Sensoren mit Lichtschranken und Umlenkspiegeln zum Einsatz, wie sie z.B. in der DE 197 28 478 A1 offenbart sind. Eine Steuereinheit signalisiert in diesem Fall, dass das entsprechende Aktorelement die zugeordnete Übertragungsrolle 50 entkoppelt und das Antriebsrollenelement 42 abbremst. Wenn dieser Vorgang für alle Waferscheiben 20 durchgeführt wurde, die positioniert werden sollen, wird die Drehrichtung der Antriebsrolle umgekehrt und es wird eine Feinausrichtung in entgegengesetzter Richtung mit kleinerer Drehgeschwindigkeit ausgeführt. Dabei ist es möglich, die Vorrichtung so einzustellen, dass die einzelnen Waferkerben 22 aus dem Detektierbereich der Sensoreinheiten 80 beim Bremsen herausgedreht und dann durch die Feinausrichtung mit niedriger Geschwindigkeit wieder in den Detektierbereich hereingedreht und beim abermaligen Auslösen des Sensorsignals endgültig abgebremst werden (binäre Detektierung). Es ist aber auch möglich, den Detektierbereich der Sensoreinheiten 80 so gross vorzusehen, dass beim Abbremsen die Kerben 22 nicht den Detektierbereich verlassen und die Feinausrichtung innerhalb des Detektierbereichs durchgeführt wird, wobei dann das Detektiersignal eine azimutale Position der Kerbe im Detektierbereich beinhaltet. Für diesen Fall wiederum kann das Positionssignal als Digitalsignal oder als Analogsignal vorliegen.

In einem zweiten Ausführungsbeispiel ist die Vorrichtung zur Positionierung von Waferscheiben 20 als Ganzes mit 200 bezeichnet. Die Waferscheiben 20 sind wiederum auf zwei Lagerungsrollen 30 und 32 mit einzeln gelagerten Führungsrollen 34 stehend gelagert.

Wie im ersten Ausführungsbeispiel werden die Waferscheiben 20 wiederum durch die Antriebsrollenelemente 42 angetrieben. Die Antriebsrollenelemente 42 werden im zweiten Ausführungsbeispiel jedoch dadurch selektiv angetrieben, dass jedem Antriebsrollenelement 42 ein eigener Antriebsmotor 240 zugeordnet ist, der mit dem Antriebselement mit einem Riemen 242 oder einem gleichwirkenden Übertragungselement verbunden ist. Jeder Antriebsmotor ist durch eine Steuerungseinrichtung einzeln angesteuert. Die Steuerungseinrichtung ist - wie im ersten Ausführungsbeispiel - mit einer Sensoreinheit verbunden, die die azimutale Position der Kerben 22 in den Waferscheiben 20 detektieren.

Der zum ersten Ausführungsbeispiel beschriebene Verfahrensablauf mit der Drehung der Waferscheiben mit einer ersten, höheren Drehgeschwindigkeit, dem Abbremsen und einer Feinausrichtung in gegengesetzter Drehrichtung bei kleinerer Drehgeschwindigkeit ist beim zweiten Ausführungsbeispiel ebenfalls sinnvoll, da dann ebenfalls keine Abstimmung der - ersten, höheren - Drehgeschwindigkeit und der Genauigkeit der Detektierung notwendig ist, sondern diese auf die Feinausrichtung verlagert werden kann. In diesem Fall übernimmt der jeweilige Elektromotor die Funktion der Bremse.

Im vorliegenden Ausführungsbeispiel wird anschliessend an die azimutale Positionierung der Waferscheiben 20 ein Waferidentifizierungsprozess durchgeführt, bei dem mit einer Kamera 90 eine im Aussenbereich der Scheiben 20 befindliche Kennung ausgelesen wird. Da diese Kennung in einem festen Winkel bezüglich der Kerben auf den Wafern angeordnet ist, ist die azimutale Ausrichtung der Waferscheiben bezüglich der Kerben notwendig, um das Auslesen der Kennung und die Identifizierung der Wafer mit der Kamera durchführen zu können.

## Patentansprüche

1. Vorrichtung zum Ausrichten einer Vielzahl von stehend gelagerten Scheiben (20), insbesondere Waferscheiben bei der Fertigung von Halbleiterchips, mit
- einem ersten Lagerungselement (30),
- einem in einem Abstand vom ersten Lagerungselement (30) angeordneten zweiten Lagerüngselement (32), wobei die Lagerungselemente (30, 32) nebeneinander positionierte, einzeln gelagerte Führungsrollen (34) für jede Scheibenposition aufweisen, die wiederum Mittel (36) zur Aufnahme der Scheiben aufweisen,
- einer Antriebseinrichtung (40, 42; 50, 60; 240, 242) zum Verdrehen der Scheiben bezüglich ihrer azimutalen Position,
- einem Mittel (80) zum Detektieren der azimutalen Positionen von im Außenumfang befindlichen Kerben (22) in den Scheiben (20), und
- einer Einrichtung zum Steuern der Antriebseinrichtung mit den Signalen des Mittels (80) zum Detektieren der azimutalen Positionen der Kerben (22), wobei
- die Antriebseinrichtung zum Verdrehen der Scheiben bezüglich ihrer azimutalen Position ein einzeln angetriebenes, auf einer feststehenden Achse (40) aufgezogenes Antriebsrollenelement (42) für jede Scheibe (20) aufweist,
- die Antriebsrollenelemente (42) selektiv antreibbar sind, und
- das Mittel zum Detektieren der azimutalen Position für jede Scheibe eine Sensoreinheit aufweist.

2. vorrichtung zum Ausrichten nach Anspruch 1, **dadurch gekennzeichnet, dass** die Antriebseinrichtung zum Verdrehen der Scheiben bezüglich ihrer azimutalen Position weiterhin aufweist:
- eine zweite, durch ein Antriebselement angetriebene Antriebsrolle (60), die sich über die Länge der auf der feststehenden Achse (40) aufgezogenen Antriebsrollenelemente (42) erstreckt,
- eine Vielzahl von Übertragungsrollen (50) zur selektiven Übertragung der Antriebsbewegung der zweiten Antriebsrolle (60) auf die einzelnen Antriebsrollenelemente (42), sowie
- eine Vielzahl von Aktorelementen (70) zur Kopplung der zweiten Antriebsrolle (60) mit den Antriebsrollenelementen (42) durch einzelne der Übertragungsrollen (50).

3. Vorrichtung nach Anspruch 2, **dadurch gekennzeichnet, dass** die Aktorelemente (70) die Übertragungsrollen (50) durch ein Verschwenken eines Hebels (54) in Eingriff mit der zweiten Antriebsrolle (60) und dem jeweiligen Antriebselement (42) gebracht werden können, wobei das jeweilige Aktorelement (70) das Verschwenken des Hebels (54) bewirkt.

4. Vorrichtung zum Ausrichten nach Anspruch 2 oder 3, **gekennzeichnet durch** eine Vielzahl von Bremselementen (56), die jeweils einer Übertragungsrolle (50) zugeordnet sind und mit denen die Antriebselemente (42) dann abgebremst werden, wenn die entsprechende Übertragungsrolle (50) keinen gekoppelten Zustand zwischen der zweiten Antriebsrolle (60) und dem entsprechenden Antriebselement (42) bewirkt.

5. Vorrichtung zum Ausrichten nach Anspruch 4, **dadurch gekennzeichnet, dass** das jeweilige Bremselement (56) auf einer der jeweiligen Übertragungsrolle (50) entgegengesetzten Seite des Hebels (54) angebracht ist.

6. Vorrichtung zum Ausrichten nach einem der vorstehenden Ansprüche, **dadurch gekennzeichnet, dass** das Mittel (80) zum Detektieren der azimutalen Positionen von im Außenumfang befindlichen Kerben in den Scheiben eine Vielzahl von optischen Sensoren umfasst.

7. Vorrichtung zum Ausrichten nach Anspruch 1, **dadurch gekennzeichnet, dass** die Antriebseinrichtung zum Verdrehen der Scheiben bezüglich ihrer azimutalen Position weiterhin aufweist:
- eine Vielzahl von einzeln angesteuerten Antriebselementen (240) und
- eine Vielzahl von Übertragungselementen (242) zur Übertragung der Antriebsbewegung von dem jeweiligen Antriebselement (240) auf das jeweilige Antriebsrollenelement (42).

8. Vorrichtung zum Ausrichten nach Anspruch 7, **dadurch gekennzeichnet, dass** die einzeln angesteuerten Antriebselemente (240) Elektromotoren umfassen und die Übertragungselemente (242) Riemen aufweisen, mit denen die Elektromotoren die Antriebsrollenelemente (42) antreiben.

9. Verfahren zum Ausrichten einer Vielzahl von stehend gelagerten Scheiben (20), insbesondere Waferscheiben bei der Fertigung von Halbleiterchips, wobei die Scheiben (20) auf einem ersten Lagerungselement (30) und einem in einem Abstand vom ersten Lagerungselement (30) angeordneten zweiten Lagerungselement (32) stehend gelagert sind, wobei die Lagerungselemente (30, 32) nebeneinander positionierte, einzeln gelagerte Führungsrollen (34) für jede Scheibenposition aufweisen, die wiederum Mittel (36) zur aufnahme der Scheiben (20) aufweisen, die Scheiben (20) mit einer Antriebseinrichtung (40, 42; 50, 60; 240, 242) zum Verdrehen der Scheiben (20) bezüglich ihrer azimutalen Position verdreht werden, und
die Scheiben (20) mit der Antriebseinrichtung zum Verdrehen der Scheiben bezüglich ihrer azimutalen Position jeweils mit einzeln angetriebenen, auf einer feststehenden Achse (40) aufgezogenen Antriebsrollenelementen (42) verdreht werden,
- für jede Scheibe eine Sensoreinheit (80) vorgesehen ist, die ein Signal auslost, sobald eine bestimmte azimutale Position der Scheibe erkannt wird,
- die Antriebsrollenelemente (42) mittels einer Einrichtung zum Steuern der Antriebseinrichtung selektiv angetrieben werden, wozu
- die Einrichtung zum Steuern der Antriebseinrichtung mit Signalen der Sensoreinheiten (80) mit den Sensoreinheiten (80) verbanden ist.

10. Verfahren zum Ausrichten nach Anspruch 9, **dadurch gekennzeichnet, dass** die Scheiben dadurch einzeln verdreht werden, dass
- eine zweite, durch ein Antriebselement angetriebene Antriebsrolle (60), die sich über die Länge der auf der feststehenden Achse (40) aufgezogenen Antriebsrollenelemente (42) erstreckt, ständig angetrieben wird,
- eine einzelne aus einer Vielzahl von Übertragungsrollen (50) durch ein einzelnes aus einer Vielzahl von Aktorelementen (70) die zweiten Antriebsrolle (60) mit den Antriebsrollenelementen (42) koppelt.

11. Verfahren nach Anspruch 9, **dadurch gekennzeichnet, dass** aus einer Vielzahl von Übertragungselementen (242) zur Übertragung der Antriebsbewegung jeweils von einem Abtriebselement (240) auf ein Antriebsrollenelement (42) ein Übertragungselement (242) aktiviert wird und damit ein Antriebsrollenelement (42) dem zugeordneten Antriebselement (240) in Verbindung steht.

12. Verfahren nach Anspruch 9 bis 11, **dadurch gekennzeichnet, dass** die Vielzahl von Scheiben (20) so verdreht werden, indem
(a) jede der Scheiben (20) mit einer ersten Geschwindigkeit in einer ersten Richtung verdreht werden, bis ein Mittel zum Detektieren der azimutalen Positionen von im Außenumfang befindlichen Kerben (22) in den Scheiben (20) die Position der Kerbe (22) in seinem Detektierbereich detektiert,
(b) die jeweilige Scheibe (20) durch ein Bremselement (70) abbremst und
(c) die jeweilige scheibe mit einer zweiten, niedrigeren Geschwindigkeit in entgegengesetzter Drehrichtung innerhalb des Detektierbereichs zur Peinausrichtung gedreht wird, wobei der Vorgang (c) durchgeführt wird, nachdem alle zu positionierenden Scheiben (20) abgebremst wurden.

## Claims

1. A device for aligning a number of disks (20), in particular wafers, which are stored upright in the production of semiconductor chips, having
- a first bearing element (30),
- a second bearing element (32), which is arranged at a distance from the first bearing element (30), such that the bearing elements (30, 32) have individually mounted guide rolls (34) for each wafer positioned side by side, these guide rolls in turn having means (36) to receive the wafers,
- a drive mechanism (40, 42; 50, 60; 240, 242) for rotating the wafers with respect to their azimuthal position,
- a means (80) for detecting the azimuthal positions of notches (22) provided in the outside circumference of the wafers (20), and
- a device for controlling the drive mechanism with the signals of the means (80) for detecting the azimuthal positions of the notches (22), wherein
- the drive mechanism for rotating the wafers with respect to their azimuthal position has an individually driven drive roller element (42) which is placed on a stationary axle (40) for each wafer (20),
- the drive roller elements (42) can be driven selectively, and
- the means for detecting the azimuthal position for each wafer has a sensor unit.

2. The device for alignment according to Claim 1,
**characterized in that**
the drive mechanism also has the following for rotating the disks with respect to their azimuthal position:
- a second drive roller (60), which is driven by a drive element and extends over the length of the drive roller element (42), which is placed on the stationary axle (40),
- a plurality of transfer rollers (50) for selective transfer of the drive movement of the second drive roller (60) to the individual drive roller elements (42), as well as
- a plurality of actuator elements (70) for coupling the second drive roller (60) to the drive roller elements (42) by individual ones of the transfer rollers (50).

3. The device according to Claim 2,
**characterized in that**
the actuator elements (70) can bring the transfer rollers (50) into engagement with the second drive roller (60) and the respective drive element (42) through a pivoting of a lever (54), such that the respective actuator element (70) causes the pivoting of the lever (54).

4. The device for alignment according to Claim 2 or 3,
**characterized by**
a plurality of brake elements (56), each of which is assigned to one transfer roller (50) and with which the drive elements (42) are then slowed down when the corresponding transfer roller (50) does not induce a coupled state between the second drive roller (60) and the corresponding drive element (42).

5. The device for alignment according to Claim 4,
**characterized in that**
the respective brake element (56) is mounted on a side of the lever (54) opposite the respective transfer roller (50).

6. The device for alignment according to any one of the preceding claims,
**characterized in that**
means (80) for detecting the azimuthal positions of notches in the outside circumference of the wafers comprise a plurality of optical sensors.

7. The device for alignment according to Claim 1,
**characterized in that**
the drive device for rotation of the disks with respect to their azimuthal position also has the following:
- a plurality of individually controlled drive elements (240) and
- a plurality of transfer elements (242) for transfer of the drive movement from the respective drive element (240) to the respective drive roller element (42).

8. The device for alignment according to Claim 7,
**characterized in that**
the individually controlled drive elements (240) include electric motors, and the transfer elements (242) have belts with which the electric motors drive the drive roller elements (42).

9. A method for alignment of a plurality of disks (20) which are stored upright, in particular wafers in the production of semiconductor chips, where the disks (20) are stored upright on a first storage element (30) and in a second storage element (32), which is arranged at a distance from the first storage element (30), such that the storage elements (30, 32) have individually mounted guide rollers (34), which are positioned side by side for each disk position and in turn have means (36) for receiving the disks (20), the disks (20) being rotated with a drive mechanism (40, 42; 50, 60; 240, 242) for rotation of the disks (20) with respect to their azimuthal position, and
the disks (20) are rotated with the drive mechanism for rotation of the disks with respect to their azimuthal position, rotating them with individually driven drive roller elements (42) placed on a stationary axle (40),
- a sensor unit (80) is provided for each disk, triggering a signal as soon as a certain azimuthal position of the disk has been detected,
- the drive roller elements (42) are driven selectively by means of a device for controlling the drive mechanism, to which end
- the device for controlling the drive mechanism is connected to the sensor units (80) by signals of the sensor units (80).

10. The method for alignment according to Claim 9,
**characterized in that**
the disks are rotated individually by the fact that
- a second drive roller (60), which is driven by a drive element and which extends over the length of the drive roller element (42) placed on the stationary axle (40) is driven continuously,
- a single transfer roller (50) from a plurality of transfer rollers connects the second drive roller (60) to the drive roller elements (42) by means of a single one of a plurality of actuator elements (70).

11. The method according to Claim 9,
**characterized in that**
of a plurality of transfer elements (242) for transfer of the drive movement from a drive element (240) to a drive roller element (42), a transfer element (242) is activated and thus a drive roller element (42) is connected to the respective drive element (240).

12. The method according to Claims 9 through 11,
**characterized in that**
the plurality of disks (20) is rotated so that
(a) each of the disks (20) is rotated at a first speed in a first direction until means for detecting the azimuthal positions of notches (22) in the outside circumference of the disks (20) detects the position of the notch (22) in its detection range,
(b) the respective disk (20) is slowed down by a braking element (70), and
(c) the respective disk is rotated at a second lower speed in the opposite direction of rotation within the detection range for precision alignment, such that the process (c) is carried out after all the disks (20) to be positioned have been slowed down.

## Revendications

1. Dispositif d'alignement d'une pluralité de plaquettes (20) positionnées à la verticale, notamment de plaquettes en silicium lors de la fabrication de puces à semi-conducteurs, comportant
- un premier élément de positionnement (30),
- un deuxième élément de positionnement (32) disposé à un espacement par rapport au premier élément de positionnement (30), dans lequel les éléments de positionnement (30,32) présentent des rouleaux de guidage (34) positionnés individuellement les uns à côté des autres pour chaque position de plaquette, qui présentent à leur tour des moyens (36) pour recevoir les plaquettes,
- un dispositif d'entraînement (40,42 ;50,60 ;240,242) pour tourner les plaquettes en ce qui concerne leur position azimutale,
- un moyen (80) pour détecter les positions azimutales d'encoches (22) se trouvant dans la circonférence dans les plaquettes (20), et
- un dispositif pour commander le dispositif d'entraînement avec les signaux du moyen (80) pour détecter les positions azimutales des encoches (22), dans lequel
- le dispositif d'entraînement pour tourner les plaquettes en ce qui concerne leur position azimutale présente un élément de rouleau d'entraînement (42) entraîné individuellement, enfilé sur un axe fixe (40) pour chaque plaquette (20),
- les éléments de rouleau d'entraînement (42) peuvent être entraînés sélectivement, et
- le moyen pour détecter les positions azimutales de chaque plaquette présente une unité de capteur.

2. Dispositif d'alignement selon la revendication 1, **caractérisé en ce que** le dispositif d'entraînement pour tourner les plaquettes en ce qui concerne sa position azimutale présente en outre :
- un deuxième rouleau d'entraînement (60) entraîné par un élément d'entraînement, qui s'étend sur la longueur des éléments de rouleau d'entraînement (42) enfilés sur l'axe fixe (40),
- une pluralité de rouleaux de transmission (50) pour transmettre sélectivement le mouvement d'entraînement du deuxième rouleau d'entraînement (60) aux éléments de rouleau d'entraînement individuels (42), ainsi que
- une pluralité d'éléments d'actionneur (70) pour coupler le deuxième rouleau d'entrainement (60) avec les éléments de rouleau d'entraînement (42) par l'intermédiaire de rouleaux de transmission (50) individuels.

3. Dispositif selon la revendication 2, **caractérisé en ce que** les éléments d'actionneur (70) les rouleaux de transmission (50) peuvent être amenés en prise par un basculement d'un levier (54) avec le deuxième rouleau d'entraînement (60) et l'élément d'entraînement respectif (42), dans lequel l'élément d'actionneur respectif (70) provoque le basculement du levier (54).

4. Dispositif d'alignement selon les revendications 2 ou 3, **caractérisé par** une pluralité d'éléments de freinage (56), qui sont respectivement coordonnés à un rouleau de transmission (50) et avec lesquels les éléments d'entraînement (42) sont ensuite freinés, quand le rouleau de transmission correspondant (50) ne provoque pas d'état couplé entre le deuxième rouleau d'entraînement (60) et l'élément d'entraînement correspondant (42).

5. Dispositif d'alignement selon la revendication 4, **caractérisé en ce que** l'élément de freinage respectif (56) est monté sur un côté opposé au rouleau de transmission respectif (50) du levier (54).

6. Dispositif d'alignement selon une des revendications précédentes, **caractérisé en ce que** le moyen (80) pour détecter les positions azimutales d'encoches se trouvant dans le circonférence extérieure dans les plaquettes comprend une pluralité de capteurs optiques.

7. Dispositif d'alignement selon la revendication 1, **caractérisé en ce que** le dispositif d'entraînement pour tourner les plaquettes en ce qui concerne leur position azimutale présente en outre :
- une pluralité d'éléments d'entraînement (240) commandés individuellement et
- une pluralité d'éléments de transmission (242) pour transmettre le mouvement d'entraînement par l'élément d'entraînement respectif (240) sur l'élément de rouleau d'entrainement respectif (42).

8. Dispositif d'alignement selon la revendication 7, **caractérisé en ce que** les éléments d'entraînement commandés individuellement (240) comprennent des moteurs électriques et les éléments de transmission (242) présentent des courroies, avec lesquels les moteurs électriques entraînent les éléments de rouleau d'entraînement (42).

9. Procédé d'alignement d'une pluralité de plaquettes (20) positionnées à la verticale, notamment de plaquettes en silicium lors de la fabrication de puces à semi-conducteurs, dans lequel les plaquettes (20) sont positionnées à la verticale sur un premier élément de positionnement (30) et un deuxième élément de position (32) disposé en espacement par rapport au premier élément de positionnement (30), dans lequel les éléments de positionnement (30,32) présentent des rouleaux de guidage (34) positionnés individuellement côté à côte pour chaque position de plaquette, qui présentent à leur tout un moyen (36) pour recevoir les plaquettes (20), les plaquettes (20) sont tournées par un dispositif d'entraînement (40,42 ;50,60 ;240,242) pour tourner les plaquettes en ce qui concerne leur position azimutale, et
- les plaquettes (20) sont tournées avec le dispositif d'entraînement pour tourner les plaquettes en ce qui concerne leur position azimutale respectivement des éléments de rouleau d'entraînement (42) entraînés individuellement, enfilés sur un axe fixe,
- pour chaque disque une unité de capteur (80) est prévue, qui déclenche un signal dès qu'une position azimutale déterminée de la plaquette est détectée,
- les éléments de rouleaux d'entraînement (42) sont entraînés sélectivement au moyen d'un dispositif pour commander le dispositif d'entraînement, où
- le dispositif de commande du dispositif d'entraînement est relié aux signaux des unités de capteur (80) avec les unités de capteur (80).

10. Procédé d'alignement selon la revendication 9, **caractérisé en ce que** les plaquettes sont tournées individuellement **en ce que**
- un deuxième rouleau d'entraînement (60), entraîné par un élément d'entraînement, qui s'étend sur la longueur des éléments de rouleau d'entrainement (42) enfilés sur l'axe fixe (40), est entraîné en permanence,
- un élément individuel constitué d'une pluralité de rouleaux de transmission (50) couple le deuxième rouleau d'entraînement (60) avec les éléments de rouleau d'entraînement (42) par l'intermédiaire d'un élément individuel constitué d'une pluralité d'éléments d'actionneur (70).

11. Procédé selon la revendication 9, **caractérisé en ce que** un élément de transmission (242) constitué d'une pluralité d'éléments de transmission (242) pour transmettre le mouvement d'entraînement respectivement d'un élément d'entraînement (240) à un élément de rouleau d'entraînement (42) et ainsi un élément de rouleau d'entraînement (42) se trouve en liaison avec l'élément d'entraînement coordonné (240).

12. Procédé selon les revendications 9 à 11, **caractérisé en ce que** la pluralité de plaquettes (20) sont tournées de telle sorte que
(a) chacune des plaquettes (20) est tournée avec une première vitesse dans une première direction, jusqu'à ce qu'un moyen pour détecter les positions azimutales des encoches (22) se trouvant dans la circonférence extérieure dans les plaquettes (20) détecte la position des encoches (22) dans sa plage de détection,
(b) les plaquettes respectives (20) est freinée par un élément de freinage (70) et
(c) la plaquette respective est tournée avec une deuxième vitesse réduite dans la direction de rotation opposée à l'intérieur de la plage de détection à des fins d'alignement de précision, dans lequel le processus (c) est effectué, après que toutes les plaquettes à positionner (20) ont été freinées.
